(19) **Europäisches Patentamt / European Patent Office / Office européen des brevets**

(11) **EP 2 203 976 B1**

(12) **FASCICULE DE BREVET EUROPEEN**

(45) Date de publication et mention
de la délivrance du brevet:
**11.05.2011 Bulletin 2011/19**

(21) Numéro de dépôt: **08842063.3**

(22) Date de dépôt: **22.10.2008**

(51) Int Cl.:
***H03H 9/02*** *(2006.01)*

(86) Numéro de dépôt international:
**PCT/EP2008/064303**

(87) Numéro de publication internationale:
**WO 2009/053397 (30.04.2009 Gazette 2009/18)**

(54) **RESONATEUR A ONDES DE LAMB**

LAMBWELLENRESONATOR

LAMB WAVE RESONATOR

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **22.10.2007 FR 0758470**

(43) Date de publication de la demande:
**07.07.2010 Bulletin 2010/27**

(73) Titulaires:
• **STMicroelectronics SA**
**92120 Montrouge (FR)**
• **Centre National de la Recherche Scientifique**
**75016 Paris (FR)**

(72) Inventeurs:
• **BELOT, Didier**
**F-38140 Rives (FR)**
• **CATHELIN, Andreia**
**F-38190 Laval (FR)**
• **SHIRAKAWA, Alexandre, Augusto**
**95123 San Jose**
**California (US)**
• **PHAM, Jean-Marie**
**F-33700 Merignac (FR)**
• **JARY, Pierre**
**F-33400 Talence (FR)**
• **KERHERVE, Eric**
**F-33400 Talence (FR)**

(74) Mandataire: **Ilgart, Jean-Christophe et al**
**BREVALEX**
**95 rue d'Amsterdam**
**75378 Paris Cedex 8 (FR)**

(56) Documents cités:
**WO-A-2004/109913**

• **BJURSTROM ET AL: "Thin film Lamb wave resonant structures - The first approach" SOLID STATE ELECTRONICS, ELSEVIER SCIENCE PUBLISHERS, BARKING, GB, vol. 50, no. 3, mars 2006 (2006-03), pages 322-326, XP005402328 ISSN: 0038-1101**
• **DESVERGNE, M. DEFAY, E. WOLOZAN, D. AID, M. VINCENT, P. VOLATIER, A. DEVAL, Y. BEGUERET, J.-B.: "Intermediate frequency lamb wave coupled resonator filters for RF receiver architectures" 37TH EUROPEAN SOLID STATE DEVICE RESEARCH CONFERENCE 2007, ESSDERC, [Online] 13 septembre 2007 (2007-09-13), pages 358-361, XP002473840 ISSN: 1930-8876 ISBN: 978-1-4244-1123-8**
• **YASUHIKO NAKAGAWA, MASAYUKI MOMOSE, AND SHOJI KAKIO: "Resonators Using a Lamb Wave on AT-Cut Quartz" JPANESE JOURNAL OF APPLIED PHYSICS, vol. 46, no. 7b, 26 juillet 2007 (2007-07-26), pages 4665-4668, XP002473841**
• **RUBY R ET AL: "The Effect of Perimeter Geometry on FBAR Resonator Electrical Performance (formerly titled FBAR: State of the Union)" MICROWAVE SYMPOSIUM DIGEST, 2005 IEEE MTT-S INTERNATIONAL LONG BEACH, CA, USA 12-17 JUNE 2005, PISCATAWAY, NJ, USA,IEEE, 12 juin 2005 (2005-06-12), pages 217-220, XP010844726 ISBN: 0-7803-8846-1**

## Description

## DOMAINE TECHNIQUE

L'invention concerne le domaine des résonateurs, ainsi que celui des filtres obtenus à partir de résonateurs à ondes de Lamb. Ces filtres sont par exemple utilisés dans des architectures d'émission et/ou de réception RF (radiofréquence), telles que des dispositifs de communication mobiles, pour réaliser par exemple un filtrage de canal ou un filtrage de fréquence intermédiaire.

## ÉTAT DE LA TECHNIQUE ANTÉRIEURE

Pour la réalisation d'un filtrage RF, il est connu d'utiliser des filtres SAW (à ondes acoustiques de surface), réalisés à partir de résonateurs SAW couplés. Typiquement, pour un tel filtre de dimensions égales à environ 3 mm × 3 mm × 1 mm, les pertes d'insertion peuvent être comprises entre environ 2,5 dB et 3 dB et présenter une réjection égale à environ 30 dB. Toutefois, ces filtres présentent des limitations : les fréquences de résonance maximum sont en général égales à environ 3 GHz et la tenue en puissance maximale est égale à environ 1 W. En dehors de cette plage de fonctionnement, les dispositifs SAW présentent des pertes de propagation importantes.

Il est également connu de l'art antérieur de réaliser des filtres, appelés filtres BAW (à ondes acoustiques de volume) à partir de résonateurs piézoélectriques BAW couplés électriquement (avec par exemple une structure en échelle ou en treillis) ou acoustiquement (de type SCF pour « Stacked Crystal Filter » ou CRF pour « Coupled Resonator Filter »). Dans un tel filtre, le signal à filtrer se propage de manière verticale dans des couches résonantes empilées, directement ou par l'intermédiaire d'un milieu de propagation acoustique, les unes sur les autres. Les dimensions et les pertes d'insertion pouvant être obtenues à partir de ces filtres BAW sont comparables à celles des filtres SAW. Cependant, la tenue en puissance de ces filtres BAW peut atteindre environ 3 W et les fréquences de résonance maximum peuvent être supérieures à environ 16 GHz. Enfin, la réalisation de ces filtres est compatible avec les technologies CMOS et BiCMOS.

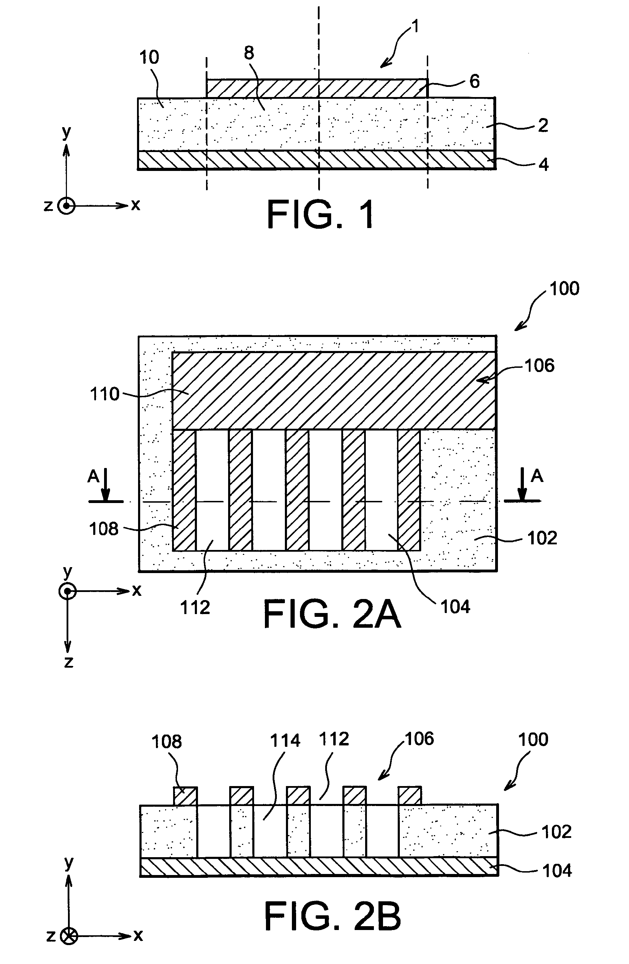

La figure 1 représente un exemple de résonateur BAW 1, comportant une couche 2 à base d'un matériau piézoélectrique, une électrode inférieure 4 et une électrode supérieure 6. Les dimensions de l'électrode inférieure 4 et de la couche piézoélectrique 2 sont sensiblement similaires les unes par rapport aux autres dans un plan parallèle au plan (x,z) (selon les axes x et z représentés sur la figure 1), l'électrode inférieure 4 étant alors complètement recouverte par la couche piézoélectrique 2. Par contre, l'électrode supérieure 6 a une forme et des dimensions différentes de celles de l'électrode inférieure 4. Sur l'exemple de la figure 1, l'électrode supérieure 6 a une dimension selon l'axe x qui est inférieure à celle de l'électrode inférieure 4. Cette différence de dimensions entre l'électrode inférieure 4 et l'électrode supérieure 6 forme au sein de la couche piézoélectrique 2 deux zones : une première zone active 8, dans laquelle la couche piézoélectrique 2 est comprise entre les deux électrodes 4 et 6, et une seconde zone inactive 10 dans laquelle la couche piézoélectrique 2 est disposée sur l'électrode inférieure 4 sans être recouverte par l'électrode supérieure 6. La vitesse de propagation des ondes dans la zone active 8 est différente de celle dans la zone inactive 10. Cette différence de vitesses de propagation entraîne des résonances parasites dues à la propagation d'ondes latérales perpendiculairement aux ondes verticales, appelées ondes de Lamb. L'énergie des ondes de Lamb est proportionnelle à la valeur de la différence entre les constantes de propagation acoustique de volume (propagation selon l'axe y) de la zone active 8 et de la zone inactive 10.

Le document US 2006/0076852 A1 décrit des composants électroacoustiques utilisant des ondes acoustiques de volume. Dans ce document, des électrodes sont positionnées de manière périodique sur une couche piézoélectrique de manière à guider les ondes acoustiques de volume dans le composant. La valeur du coefficient piézoélectrique de cette couche au niveau des électrodes est différente de celle au niveau des parties de la couche non recouvertes par les électrodes. Cette différence au niveau du coefficient de propagation dans la couche piézoélectrique est difficile à obtenir et nécessite des étapes de traitement spécifiques de la couche piézoélectrique.

Le document « UHF/VHF resonators using Lamb waves co-integrated with Bulk Acoustic Wave resonators » de A. Volatier et al., IEEE Ultrasonics Symposium, 2005, pages 902 à 905, décrit des résonateurs à ondes de Lamb comportant une électrode de forme carrée ou rectangulaire. Dans ce document, l'ordre du mode de résonance est choisi en fonction de la fréquence de résonance souhaitée. Ces résonateurs ont notamment pour inconvénients d'avoir un facteur de qualité relativement faible et de présenter une résistance série importante.

Le document WO2004/109913 décrit un résonateur piézoélectrique à ondes de Lamb ayant une électrode qui comporte au moins deux doigts et un bras de contact, chacun des doigts comportant un premier côté en contact avec le bras et deux autres côtés parallèles l'un par rapport à l'autre, les deux côtés parallèles étant espacés d'une distance prédéterminée.

## EXPOSÉ DE L'INVENTION

Un but de la présente invention est de proposer un résonateur à ondes de Lamb dont la géométrie permet d'exploiter au mieux l'énergie de résonance des ondes de Lamb, tout en comprenant un facteur de qualité élevé et une résistance série faible par rapport aux résonateurs de l'art antérieur, et dont la réalisation ne nécessite pas d'étape de traitement spécifique de couche piézoélectrique.

Pour cela, la présente invention propose un résonateur à ondes de Lamb, comportant au moins une couche à base d'au moins un matériau piézoélectrique, et une première électrode disposée contre une première face de la couche piézoélectrique et dont le motif, dans un plan parallèle au plan de la première face de la couche piézoélectrique, comporte au moins deux doigts et un bras de contact, chacun des doigts comportant un premier côté en contact avec ledit bras et deux autres côtés parallèles l'un par rapport à l'autre et espacés l'un de l'autre d'une distance W calculée selon l'équation :

$$W = n.\frac{va_{latéral}}{f}, \qquad avec \quad n \in \mathbb{N}$$

$va_{latéral}$ : vitesse de propagation acoustique des ondes de Lamb,
n : ordre du mode de résonance des ondes de Lamb,
f : fréquence de résonance du résonateur,
des portions de la couche piézoélectrique dont la surface, au niveau du plan de la première face de la couche piézoélectrique, se trouve entre les doigts de la première électrode étant gravées au moins partiellement.

On dimensionne donc, en fonction de la fréquence de résonance souhaitée, de l'ordre du mode de résonance souhaité et de la vitesse de propagation acoustique mesurée ou calculée dans le résonateur, la largeur des doigts formant une partie de l'électrode supérieure du résonateur.

Ainsi, avec un tel résonateur comportant des doigts dont la largeur W est ainsi calculée, on utilise au mieux l'énergie de résonance des ondes de Lamb générées dans ce résonateur. De plus, on augmente ainsi le facteur de qualité et on réduit la résistance série du résonateur par rapport aux dispositifs de l'art antérieur.

Un tel résonateur à fort facteur de qualité permet notamment de réaliser :

-  des oscillateurs à tension de commande à très faible bruit de phase et à faible consommation,
-  des filtres de fréquences intermédiaires (comprises entre environ 10 MHz et 200 MHz) à faibles pertes d'insertion et à forte sélectivité,
-  des modulateurs sigma-delta passe-bande à très forte réjection et à très faible consommation.

De manière générale, ces avantages se retrouvent dans tout type de dispositif faisant appel à au moins un tel résonateur dans la bande des fréquences intermédiaires.

De plus, on réduit la densité du matériau piézoélectrique au niveau des zones inactives du résonateur se trouvant entre les doigts de la première électrode par une gravure au moins partielle de portions de la cou

che piézoélectrique se trouvant entre les doigts de la première électrode. Ces portions gravées créent une discontinuité des conditions de propagation acoustique entre les zones actives de la couche piézoélectrique se trouvant au niveau des doigts de la première électrode et les zones inactives de la couche piézoélectrique se trouvant entre les doigts de la première électrode. Cette discontinuité modifie les paramètres de transmission acoustique dans la couche piézoélectrique, permettant ainsi de confiner l'énergie acoustique de résonance dans la ou les zones actives du résonateur.

Ainsi, il n'est pas nécessaire de mettre en oeuvre d'étape de traitement spécifique de la couche piézoélectrique, mais seulement une ou plusieurs étapes de gravure qui peuvent être communes à la gravure d'autres éléments du résonateur.

Lesdites portions de la couche piézoélectrique peuvent être gravées, dans le plan de la première face de la couche piézoélectrique, selon un motif comportant une pluralité de trous.

Dans une variante, lesdites portions de la couche piézoélectrique peuvent être entièrement gravées.

Lesdites portions peuvent être gravées de manière traversante entre la première face de la couche piézoélectrique et une seconde face, opposée à la première face, de la couche piézoélectrique.

Le résonateur peut comporter en outre une seconde électrode disposée contre une seconde face, opposée à la première face, de la couche piézoélectrique.

La surface des doigts de la première électrode dans le plan parallèle au plan de la première face de la couche piézoélectrique peut être incluse dans la surface formée par la seconde électrode dans ce même plan.

La seconde électrode peut comporter, dans le plan parallèle au plan de la première face de la couche piézoélectrique, un motif comportant au moins deux doigts et un bras de contact, la surface des doigts de la seconde électrode dans le plan parallèle au plan de la première face de la couche piézoélectrique pouvant être similaire et superposée à la surface formée par les doigts de la première électrode dans ce même plan.

Le motif de la seconde électrode peut être similaire au motif de la première électrode dans le plan parallèle au plan de la première face de la couche piézoélectrique. La surface du bras de contact de la seconde électrode dans le plan parallèle au plan de la première face de la couche piézoélectrique peut ne pas être superposée à la surface du bras de contact de la première électrode dans ce même plan.

Chaque doigt de la première électrode peut être de forme sensiblement rectangulaire.

La première électrode peut comporter entre environ 2 et 100 doigts, et de préférence au moins 4 doigts.

Le bras de contact de la première électrode peut être de forme sensiblement rectangulaire.

Une droite parallèle aux deux côtés de chaque doigt de la première électrode espacés l'un de l'autre d'une distance W étant sensiblement perpendiculaire à une droite passant par un côté du bras de contact de la première électrode auquel est connecté ledit doigt.

Les doigts de la première électrode peuvent être connectés à un seul côté, ou à deux côtés opposés, ou à trois côtés, du bras de contact de la première électrode.

Dans une variante, le bras de contact de la première électrode peut comporter au moins une partie de forme sensiblement circulaire à laquelle les doigts sont connectés.

La présente invention concerne également un procédé de réalisation d'un résonateur à ondes de Lamb, comportant au moins une étape de réalisation d'une première électrode contre une première face d'une couche à base d'au moins un matériau piézoélectrique, dont le motif, dans un plan parallèle au plan de la première face de la couche piézoélectrique, comporte au moins deux doigts et un bras de contact, chacun des doigts comportant un premier côté en contact avec ledit bras et deux côtés parallèles l'un par rapport à l'autre et espacés l'un de l'autre d'une distance W calculée selon l'équation :

$$W = n.\frac{va_{latéral}}{f}, \qquad avec \quad n \in \mathrm{N}$$

$va_{lateral}$ : vitesse de propagation acoustique des ondes de Lamb,
n : ordre du mode de résonance des ondes de Lamb,
f : fréquence de résonance du résonateur,
et au moins une étape de gravure au moins partielle de portions de la couche piézoélectrique dont la surface, au niveau du plan de la première face de la couche piézoélectrique, se trouve entre les doigts de la première électrode.

Le procédé peut comporter en outre, par exemple après l'étape de réalisation de la première électrode, une étape de réalisation d'une seconde électrode contre une seconde face, opposée à la première face, de la couche piézoélectrique.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- la figure 1 représente un résonateur BAW selon l'art antérieur,
- les figures 2A et 2B représentent respectivement une vue de dessus et une vue en coupe d'un résonateur à ondes de Lamb, objet de la présente invention, selon un premier mode de réalisation,
- les figures 3 à 6 représentent respectivement des vues de dessus de résonateurs à ondes de Lamb, objets de la présente invention, respectivement selon un second, troisième, quatrième et cinquième mode de réalisation,
- les figures 7A et 7B représentent respectivement une vue de dessus et une vue en coupe d'un résonateur à ondes de Lamb, objet de la présente invention, selon un sixième mode de réalisation,
- les figures 8A et 8B représentent respectivement une vue de dessus et une vue en coupe d'un résonateur à ondes de Lamb, objet de la présente invention, selon une variante du premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

On se réfère tout d'abord aux figures 2A et 2B qui représentent respectivement une vue de dessus et une vue en coupe selon un axe AA, représenté sur la figure 2A, d'un résonateur à ondes de Lamb 100 selon un premier mode de réalisation.

Ce résonateur 100 comporte une couche 102 à base d'un matériau piézoélectrique. De préférence, ce matériau piézoélectrique est du nitrure d'aluminium, et/ou de l'oxyde de zinc et/ou encore du PZT. La couche piézoélectrique 102 a une épaisseur dont la valeur est fonction des techniques de réalisation ainsi que de la forme et des dimensions des autres éléments du résonateur 100 (elles-mêmes fonction du coefficient de couplage K du résonateur souhaité). L'épaisseur de la couche piézoélectrique 102 peut notamment être comprise entre environ 1 μm et 2 μm. Cette couche piézoélectrique 102 est disposée sur une électrode inférieure 104 visible sur la figure 2B. Ici, la forme et les dimensions de la couche piézoélectrique 102 dans un plan parallèle au plan (x,z) sont sensiblement similaires à celles de l'électrode inférieure 104 dans ce même plan.

Le résonateur 100 comporte également une autre électrode, appelée électrode supérieure 106, réalisée sur la couche piézoélectrique 102. Cette électrode supérieure 106 comporte une pluralité de doigts 108 reliés à un bras de contact 110. Dans ce premier mode de réalisation, l'électrode supérieure 106 comporte cinq doigts 108. Le bras de contact 110 et l'électrode inférieure 104 sont utilisés en tant que contacts électriques du résonateur 100. L'électrode supérieure 106, c'est-à-dire le bras de contact 110 et les doigts 108, a par exemple une épaisseur comprise entre environ 0,1 $\mu$m et 1 $\mu$m. Le bras de contact 110 a ici une longueur (dimension selon l'axe x de la figure 2A) et une largeur (dimension selon l'axe z de la figure 2A) comprises entre environ 1 $\mu$m et 300 $\mu$m. Un bras de contact 110 dont la largeur est supérieure à la longueur permet d'augmenter le facteur de qualité du résonateur 100 tout en diminuant la résistance du bras de contact 110, et donc la résistance série du résonateur 100. Dans ce premier mode de réalisation, la longueur et la largeur de la couche piézoélectrique 102 et de l'électrode inférieure 104 sont adaptées pour que la surface de l'électrode supérieure 106, dans le plan (x,z), soit incluse dans celle de l'électrode inférieure 104 ou de la couche piézoélectrique 102 dans ce même plan.

Les électrodes 104 et 106 peuvent être réalisées de manière classique par un dépôt PVD (dépôt physique en phase vapeur), par exemple de platine, et/ou d'aluminium, et/ou de molybdène et/ou de tungstène, puis une gravure plasma.

Les doigts 108 forment des zones de discontinuité 112 de l'électrode supérieure 106 sur la couche piézoélectrique 102, ces zones de discontinuité 112 étant séparées par les doigts 108. Dans ce premier mode de réalisation, les doigts 108 ont chacun une forme rectangulaire dont la largeur W, c'est-à-dire la dimension selon l'axe x, est calculée selon l'équation suivante :

$$W = n.\frac{va_{latéral}}{f}, \qquad avec \quad n \in \mathbb{N}$$

Cette dimension W représente donc la distance entre deux zones de discontinuité 112 de l'électrode supérieure 106 sur la couche piézoélectrique 102.

« $va_{latéral}$ » représente la vitesse de propagation acoustique des ondes de Lamb. Cette vitesse est proportionnelle aux paramètres géométriques et de résonance du matériau de la couche 102, ainsi que des propriétés acoustiques des électrodes 104, 106 et plus généralement du résonateur 100.

« n » représente la distance acoustique entre deux zones de discontinuité 112 de l'électrode supérieure 106 séparées par un doigt 108, c'est-à-dire l'ordre du mode de résonance des ondes de Lamb dans le résonateur 100.

Enfin, f est la fréquence de résonance du résonateur 100. La valeur maximale de cette fréquence de résonance f est fonction de la largeur minimale des doigts 108 réalisable correspondant à la valeur du noeud technologique dans lequel est réalisé le résonateur 100. Si le résonateur 100 est réalisé en technologie 35 nm, cette largeur minimale est égale à 35 nm, correspondant pour le résonateur à une fréquence de résonance f maximale égale à quelques centaines de MHz, c'est-à-dire inférieure à environ 1 GHz.

On dimensionne donc les doigts 108 en calculant, à partir des caractéristiques de résonance de la couche 102, de la géométrie de la couche 102 et des électrodes 104, 106, la vitesse de propagation acoustique des ondes de Lamb $Va_{latéral}$. En fonction du mode de propagation et de la fréquence de résonance souhaités, on peut donc calculer W et ainsi dimensionner les doigts 108 de l'électrode supérieure 106. La largeur W des doigts 108 est par exemple égale à 1 $\mu$m, ou comprise entre environ 1 $\mu$m et 100 $\mu$m et la longueur de ces doigts 108 est par exemple comprise entre environ 10 $\mu$m et 50 $\mu$m. De plus, l'espace entre les doigts 108 est par exemple compris entre environ 1 $\mu$m et 10 $\mu$m. Enfin, dans ce premier mode de réalisation, les doigts 108 forment avec le bras de contact 110 un motif de peigne. Les doigts 108 forment des rectangles disposés perpendiculairement au bras de contact 110 également de forme sensiblement rectangulaire, c'est-à-dire qu'une droite parallèle aux deux côtés d'un doigt 108 espacés l'un de l'autre de la distance W est perpendiculaire à la droite passant par le côté du bras de contact 110 auquel est connecté ledit doigt 108.

Les portions de la couche piézoélectrique 102 se trouvant entre un doigt 108 de l'électrode supérieure 106 et l'électrode inférieure 104 forment les zones actives du résonateur 100. Entre ces zones actives, c'est-à-dire au niveau des zones de discontinuité 112, les portions de la couche piézoélectrique 102 sont gravées de manière traversante dans la couche 102. Comme représenté sur la figure 2A, cette gravure forme des creux 114 dans la couche piézoélectrique 102, entre les doigts 108. Ces creux 114 forment les zones inactives du résonateur 100.

Dans ce résonateur 100, ce sont les ondes de Lamb symétriques du mode $S_0$ qui contribuent principalement à obtenir la résonance souhaitée. L'énergie des ondes de Lamb est proportionnelle à la différence entre la vitesse de propagation de ces ondes dans les zones actives de la couche piézoélectrique 102, c'est-à-dire les zones de la couche piézoélectrique 102 se trouvant entre un doigt 108 de l'électrode supérieure 106 et l'électrode inférieure 104, et la vitesse de propagation de ces ondes dans les zones inactives de la couche piézoélectrique 102, c'est-à-dire au niveau des creux 114 formés dans la couche piézoélectrique 102 entre les doigts 108. Plus n sera choisi faible (par exemple n = 1 pour le mode fondamental), plus forte sera l'énergie de résonance obtenue sur un doigt 108.

Les creux 114 formés dans la couche piézoélectrique 102 permettent d'obtenir des conditions de propagation, notamment d'impédance acoustique et de vitesse de propagation, très différentes entre les zones actives et les zones inactives du résonateur. La constante de propagation acoustique dans les zones inactives est donc inférieure à la constante de propagation acoustique dans les zones actives, ce qui permet de confiner l'énergie de propagation au niveau des zones actives du résonateur.

En couplant acoustiquement deux résonateurs 100 tel que décrits précédemment, on obtient donc un filtre résonant permettant d'obtenir une forte résonance au niveau des fréquences de résonance parasite $f_k = k.f$ avec k nombre entier naturel non nul et f fréquence de résonance du filtre 100.

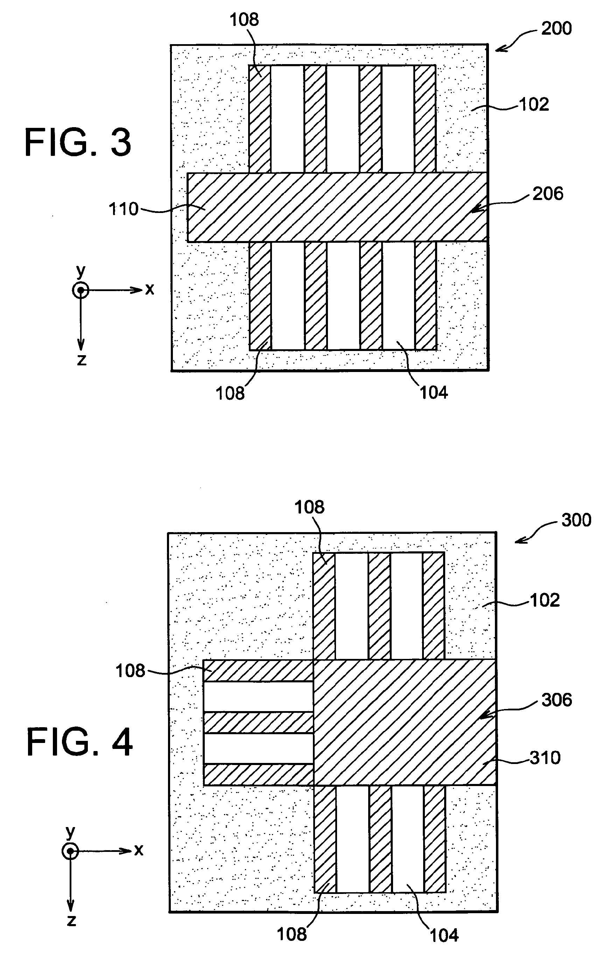

La figure 3 représente un résonateur à ondes de Lamb 200 selon un second mode de réalisation. Par rapport à l'électrode supérieure 106 du résonateur 100 selon le premier mode de réalisation, l'électrode supérieure 206 de ce résonateur 200 comporte huit doigts 108, pouvant par exemple être de forme sensiblement similaire à celle des doigts 108 des figures 2A et 2B. Quatre de ces doigts 108 sont connectés à un premier côté du bras de contact 110, qui peut également être similaire au bras de contact 110 du premier mode de réalisation, les quatre autres doigts 108 étant connectés à un second côté, opposé au premier côté, du bras de contact 110. Les doigts 108 forment des rectangles disposés perpendiculairement au bras de contact 110, c'est-à-dire qu'une droite parallèle aux deux côtés d'un doigt 108 espacés l'un de l'autre de la distance W est perpendiculaire à la droite passant par le côté du bras de contact 110 auquel sont connectés les doigts 108.

La figure 4 représente un résonateur à ondes de Lamb 300 selon un troisième mode de réalisation. Par rapport aux résonateurs précédents, l'électrode supérieure 306 de ce résonateur 300 comporte neuf doigts 108, chaque doigt pouvant être de de forme sensiblement similaire à celle des doigts 108 des premier et second modes de réalisation. Trois de ces doigts 108 sont connectés à un premier côté d'un bras de contact 310. Par rapport au bras de contact 110 des deux premiers modes de réalisation, les dimensions de ce bras de contact 310 dans le plan (x,z) sont comprises entre environ 1 $\mu$m et 400 $\mu$m. Trois autres doigts 108 sont connectés à un second côté, opposé au premier côté, du bras de contact 310. Enfin, trois autres doigts 108 sont connectés à un troisième côté du bras de contact 310, ce troisième côté étant perpendiculaire aux premier et second côtés du bras de contact 310.

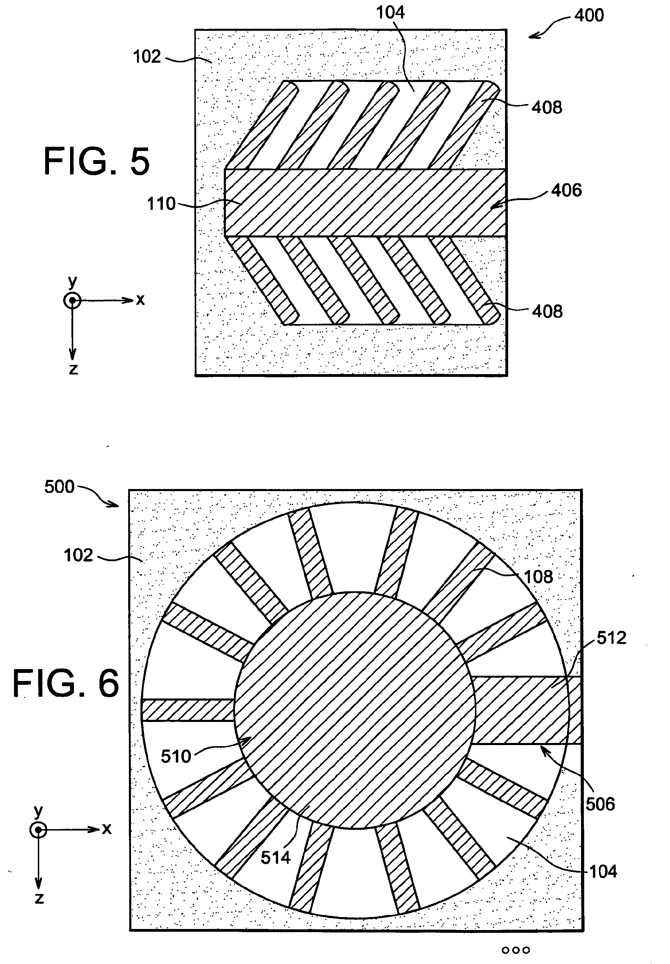

La figure 5 représente un résonateur à ondes de Lamb 400 selon un quatrième mode de réalisation. Par rapport aux résonateurs précédents, une électrode supérieure 406 du résonateur 400 comporte un bras de contact 110 par exemple similaire au bras de contact 110 des deux premiers modes de réalisation. L'électrode supérieure 406 comporte également dix doigts 408 en contact avec le bras 110. Par rapport aux doigts 108 des précédents modes de réalisation, les doigts 408 ne sont pas de forme rectangulaire. Mais comme les doigts 108, les doigts 408 comportent deux côtés parallèles espacés l'un de l'autre de la distance W calculée de manière similaire aux précédents modes de réalisation. Ces deux côtés sont en contact avec un côté du bras 110. Dans ce quatrième mode de réalisation, une droite parallèle à ces deux côtés n'est pas perpendiculaire à une droite passant par le côté du bras 110 auquel sont connecté le doigt 408. Ici, chaque doigt 408 comporte une extrémité libre de forme arrondie. Enfin, comme on peut le voir sur la figure 5, les doigts 408 sont disposés « en chevron » par rapport au bras de contact 110.

Par rapport au premier mode de réalisation, les résonateurs 200, 300 et 400 permettent, pour une même surface active, c'est-à-dire la surface couverte par les doigts 108 de l'électrode supérieure 206, 306 ou 406, d'avoir des longueurs de doigts inférieures à celles des doigts 108 de l'électrode supérieure 106 du résonateur 100, réduisant ainsi leurs résistances d'accès, et donc la résistance série du résonateur. De plus, la réduction de la longueur des doigts 108 permet de réduire l'effet inductif sur le fonctionnement du résonateur.

Un résonateur à ondes de Lamb 500 selon un cinquième mode de réalisation est représenté sur la figure 6. Par rapport aux résonateurs décrits précédemment, ce résonateur 500 comporte une électrode supérieure 506 dont le bras de contact 510 comprend une partie 512 de forme sensiblement rectangulaire connectée à une partie 514 de forme sensiblement circulaire. L'électrode supérieure 506 comporte également treize doigts 108, par exemple similaires aux doigts 108 des premier, second et troisième modes de réalisation. Ces treize doigts 108 sont connectés à la partie circulaire 514 du bras 510 et répartis régulièrement autour de cette partie circulaire.

Sur cette figure 6, on voit que les doigts 108 ne sont pas disposés parallèlement l'un par rapport à l'autre, c'est-à-dire que les deux côtés espacés l'un de l'autre de la distance W d'un premier doigt 108 ne sont pas parallèles aux deux côtés espacés l'un de l'autre de la distance W d'un second doigt 108 se trouvant à côté du premier doigt 108. Sur l'exemple de la figure 6, les axes de symétrie des doigts 108, parallèles auxdits côtés espacés de la distance W, sont ici alignés avec des diamètres du cercle formé par la partie circulaire 514 de l'électrode supérieure 506.

Par rapport au résonateur 100 selon le premier mode de réalisation, un tel résonateur 500 permet également de réduire les résistances d'accès des doigts 108 de la première électrode 506 de par leurs longueurs inférieures à celles des doigts 108 du résonateur 100. De plus, les résistances d'accès sont ici identiques pour tous les doigts 108. Ce cinquième mode de réalisation permet également de maximiser le nombre de doigts 108 pour une même surface occupée sur la couche piézoélectrique 102. Enfin, cette structure n'engendre pas d'effet inductif, ce qui est un avantage notamment lorsque le résonateur 500 fonctionne en hautes fréquences, c'est-à-dire quelques centaines de MHz.

En variante des différents modes de réalisation décrits précédemment, il possible de réaliser une gravure non traversante dans les zones inactives de la couche piézoélectrique, c'est-à-dire dans les zones de la couche piézoélectrique non recouvertes par un doigt de l'électrode supérieure, se situant entre les doigts de l'électrode supérieure.

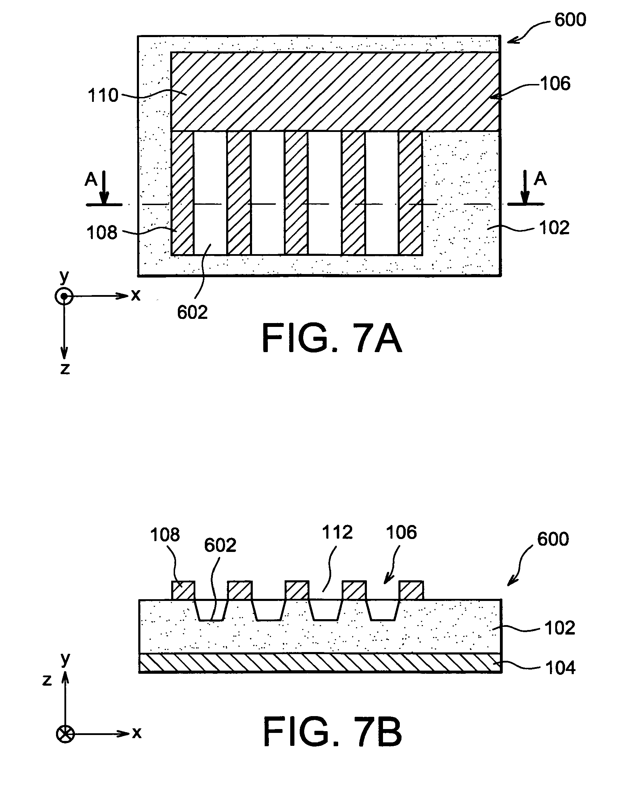

Les figures 7A et 7B représentent respectivement une vue de dessus et une vue en coupe selon l'axe AA représenté sur la figure 7A d'un résonateur 600 comportant des zones inactives gravées 602. Cette gravure permet de retirer du matériau piézoélectrique et ainsi de réduire la densité moyenne relative du matériau au niveau de ces zones inactives 602. La réduction de la densité moyenne du matériau modifie les conditions de propagations, et notamment l'impédance acoustique et la vitesse de propagation, entraînant une réduction importante de la constante de propagation de ces zones inactives. En augmentant ainsi la différence entre la constante de propagation des zones actives et celle des zones inactives, on augmente l'énergie acoustique concentrée dans les ondes de Lamb.

Il possible de réaliser cette gravure sur la totalité de la surface, dans le plan (x,z), des zones inactives entre les doigts 108 comme sur l'exemple des figures 7A et 7B, ou sur une partie seulement (par exemple en réalisant des tranchées ou des trous) de ces zones inactives.

En variante des modes de réalisation décrits précédemment, il est également possible que l'électrode inférieure ait une forme et des dimensions différentes de celles de la couche piézoélectrique 102 (dans le plan (x, z)) représentée sur la figure 2A. Dans ce cas, l'électrode inférieure peut notamment avoir un motif similaire à celui de l'électrode supérieure, respectivement 106, 206, 306, 406 ou 506 selon le mode de réalisation, et être disposée pour que les zones actives de la couche piézoélectrique se trouvent uniquement entre les doigts de l'électrode supérieure et les doigts de l'électrode inférieure, les autres portions de la couche piézoélectrique n'étant en contact qu'avec une seule des deux électrodes.

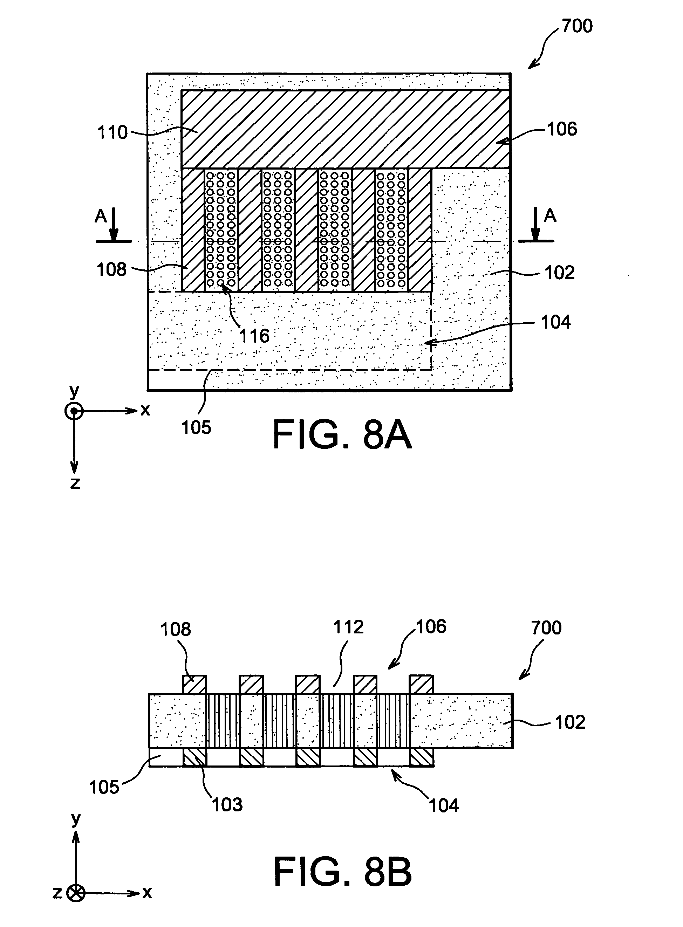

Les figures 8A et 8B représentent respectivement une vue du dessus et une vue en coupe selon l'axe AA représenté sur la figure 8A, d'un résonateur 700 dans une telle variante. Sur la figure 8A, un bras de contact 105 de l'électrode inférieure 104 est représenté en pointillé. Des doigts 103 de l'électrode inférieure 104 sont représentés sur la figure 8B. Sur ces figures, les doigts 108 de l'électrode supérieure 106 sont superposés aux doigts de l'électrode inférieure 104.

Cette variante permet notamment de réduire la longueur des bras de contact des électrodes supérieure et inférieure (dimension selon l'axe x de la figure 8B) et d'augmenter la largeur de ces bras de contact (dimension selon l'axe z de la figure 8A), ce qui réduit les résistances d'accès des différents doigts du résonateur, réduisant ainsi la résistance série du résonateur, pour une même fréquence de résonance qu'un résonateur comportant une électrode inférieure 104 telle que décrite en liaison avec les figures 2A et 2B.

De plus, dans cette variante de réalisation, les zones inactives de la couche piézoélectrique 102 sont gravées selon un motif comportant une pluralité de trous 116 traversants. Ces trous 116 permettent de réduire la densité moyenne du matériau piézoélectrique de la couche 112, et donc de modifier les conditions de propagation entre les zones actives et les zones inactives de la couche piézoélectrique 102. Dans le plan (x,y), les trous ont un diamètre d, par exemple compris entre environ 10 μm et 50 μm, tel que d << λa, avec λa : longueur d'onde acoustique latérale des ondes de Lamb, ou par exemple tel que d < (λa/10).

## Revendications

1.  Résonateur à ondes de Lamb (100, 200, 300, 400, 500, 600, 700), comportant au moins une couche (102) à base d'au moins un matériau piézoélectrique et une première électrode (106, 206, 306, 406, 506) disposée contre une première face de la couche piézoélectrique (102) et dont le motif, dans un plan parallèle au plan de la première face de la couche piézoélectrique (102), comporte au moins deux doigts (108, 408) et un bras de contact (110, 310, 510), chacun des doigts (108, 408) comportant un premier côté en contact avec ledit bras (110, 310, 510) et deux autres côtés parallèles l'un par rapport à l'autre et espacés l'un de l'autre d'une distance W calculée selon l'équation :

$$W = n. \frac{va_{latéral}}{f}, \qquad avec \ \ n \in \mathbb{N} \ ,$$

    $va_{latéral}$ : vitesse de propagation acoustique des ondes de Lamb,
    n : ordre du mode de résonance des ondes de Lamb,
    f : fréquence de résonance du résonateur,
    des portions (114, 116, 602) de la couche piézoélectrique (102) dont la surface, au niveau du plan de la première face de la couche piézoélectrique (102), se trouve entre les doigts (108, 408) de la première électrode (106, 206, 306, 406, 506) étant gravées au moins partiellement.

2.  Résonateur (700) selon la revendication 1, lesdites portions (116) de la couche piézoélectrique (102) étant gravées, dans le plan de la première face de la couche piézoélectrique (102), selon un motif comportant une pluralité de trous.

3.  Résonateur (100, 200, 300, 400, 500) selon la revendication 1, lesdites portions (114) de la couche piézoélectrique (102) étant entièrement gravées.

4.  Résonateur (100, 200, 300, 400, 500, 700) selon l'une des revendications précédentes, lesdites portions (114, 116) étant gravées de manière traversante entre la première face de la couche piézoélectrique (102) et une seconde face, opposée à la première face, de la couche piézoélectrique (102).

5.  Résonateur (100, 200, 300, 400, 500, 600, 700) selon l'une des revendications précédentes, comportant en outre une seconde électrode (104) disposée contre une seconde face, opposée à la première face, de la couche piézoélectrique (102).

6. Résonateur (100, 200, 300, 400, 500, 600, 700) selon la revendication 5, la surface des doigts (108, 408) de la première électrode (106, 206, 306, 406, 506) dans le plan parallèle au plan de la première face de la couche piézoélectrique (102) étant incluse dans la surface formée par la seconde électrode (104) dans ce même plan.

7. Résonateur (700) selon la revendication 5, la seconde électrode (104) comportant, dans le plan parallèle au plan de la première face de la couche piézoélectrique (102), un motif comportant au moins deux doigts (103) et un bras de contact (105), la surface des doigts (103) de la seconde électrode (104) dans le plan parallèle au plan de la première face de la couche piézoélectrique (102) étant similaire et superposée à la surface formée par les doigts (108) de la première électrode (106) dans ce même plan.

8. Résonateur (700) selon la revendication 7, le motif de la seconde électrode (104) dans le plan parallèle au plan de la première face de la couche piézoélectrique (104) étant similaire au motif de la première électrode (106) dans ce même plan, la surface du bras de contact (105) de la seconde électrode (104) dans le plan parallèle au plan de la première face de la couche piézoélectrique (102) n'étant pas superposée à la surface du bras de contact (110) de la première électrode (106) dans ce même plan.

9. Résonateur (100, 200, 300, 500, 600, 700) selon l'une des revendications précédentes, chaque doigt (108) de la première électrode (106, 206, 306, 506) étant de forme sensiblement rectangulaire.

10. Résonateur (100, 200, 300, 400, 500, 600, 700) selon l'une des revendications précédentes, le nombre de doigts (108, 408) de la première électrode (106, 206, 306, 406, 506) étant compris entre environ 2 et 100.

11. Résonateur (100, 200, 300, 400, 600, 700) selon l'une des revendications précédentes, le bras de contact (110, 310) de la première électrode (106, 206, 306, 406) étant de forme sensiblement rectangulaire.

12. Résonateur (100, 200, 300, 600, 700) selon la revendication 11, une droite parallèle aux deux côtés de chaque doigt (108) de la première électrode (106, 206, 306) espacés l'un de l'autre d'une distance W étant sensiblement perpendiculaire à une droite passant par un côté du bras de contact (110, 310) de la première électrode (106, 206, 306) auquel est connecté ledit doigt (108).

13. Résonateur (100, 600, 700) selon l'une des revendications 11 ou 12, les doigts (108) de la première électrode (106) étant connectés à un seul côté, ou à deux côtés opposés, ou à trois côtés, du bras de contact (110) de la première électrode (106).

14. Résonateur (500) selon l'une des revendications 1 à 10, le bras de contact (510) de la première électrode (506) comportant au moins une partie (514) de forme sensiblement circulaire à laquelle les doigts (108) sont connectés.

15. Procédé de réalisation d'un résonateur à ondes de Lamb (100, 200, 300, 400, 500, 600, 700), comportant au moins une étape de réalisation d'une première électrode (106, 206, 306, 406, 506) contre une première face d'une couche (102) à base d'au moins un matériau piézoélectrique, dont le motif, dans un plan parallèle au plan de la première face de la couche piézoélectrique (102), comporte au moins deux doigts (108, 408) et un bras de contact (110, 310, 510), chacun des doigts (108, 408) comportant un premier côté en contact avec ledit bras (110, 310, 510) et deux côtés parallèles l'un par rapport à l'autre et espacés l'un de l'autre d'une distance W calculée selon l'équation :

$$W = n.\frac{va_{latéral}}{f}, \qquad avec \quad n \in \mathrm{N}$$

$va_{latéral}$ : vitesse de propagation acoustique des ondes de Lamb,
n : ordre du mode de résonance des ondes de Lamb,
f : fréquence de résonance du résonateur,
et au moins une étape de gravure au moins partielle de portions (114, 116, 602) de la couche piézoélectrique (102) dont la surface, au niveau du plan de la première face de la couche piézoélectrique (102), se trouve entre les doigts (108, 408) de la première électrode (106, 206, 306, 406, 506).

16. Procédé selon la revendication 15, comportant en outre une étape de réalisation d'une seconde électrode (104) contre une seconde face, opposée à la première face, de la couche piézoélectrique (102).

**Claims**

1. Lamb wave resonator (100, 200, 300, 400, 500, 600, 700), comprising at least one layer (102) composed of at least one piezoelectric material, and a first electrode (106, 206, 306, 406, 506) placed against a first face of the piezoelectric layer (102), and of which the pattern, in a plane parallel to the plane or the first face of the piezoelectric layer (102), comprises at least two fingers (108, 408) and a contact arm (110, 310, 510), in which each of the fingers (108, 408) comprises a first side in contact with said arm (110, 310, 510) and two other sides parallel to one another and spaced apart from one another by a distance W calculated according to the equation:

$$W = n.\frac{va_{lateral}}{f}, \qquad with \quad n \in \mathbb{N}$$

$va_{lateral}$: acoustic propagation speed of the Lamb waves,
n: order of the resonance mode of the Lamb waves,
f: resonance frequency of the resonator,
in which portions (114, 116, 602) of the piezoelectric layer (102), of which the surface, at the level of the plane of the first face of the piezoelectric layer (102), is located between the fingers (108, 408) of the first electrode (106, 206, 306, 406, 506), are at least partially etched.

2. Resonator (700) according to claim 1, in which said portions (116) of the piezoelectric layer (102) are etched, in the plane of the first face of the piezoelectric layer (102), according to a pattern comprising a plurality of holes.

3. Resonator (100, 200, 300, 400, 500) according to claim 1, in which said portions (114) of the piezoelectric layer (102) are entirely etched.

4. Resonator (100, 200, 300, 400, 500, 700) according to one of the precious claims, in which said portions (114, 116) are etched through, between the first face of the piezoelectric layer (102) and a second face, opposite the first face, of the piezoelectric layer (102).

5. Resonator (100, 200, 300, 400, 500, 600, 700) according to one of the previous claims, also comprising a second electrode (104) arranged against a second face, opposite the first face, of the piezoelectric layer (102).

6. Resonator (100, 200, 300, 400, 500, 600, 700) according to claim 5, in which the surface of the fingers (108, 408) of the first electrode (106, 206, 306, 406, 506) in the plane parallel to the plane of the first face of the piezoelectric layer (102) is included in the surface formed by the second electrode (104) in said same plane.

7. Resonator (700) according to claim 5, in which the second electrode (104) comprises, in the plane parallel to the plane of the first face of the piezoelectric layer (102), a pattern, comprising at least two fingers (103) and a contact arm (105), in which the surface of the fingers (103) of the second electrode (104) in the plane parallel to the plane of the first face of the piezoelectric layer (102) is similar and superimposed on the surface formed by the fingers (108) of the first electrode (106) in said same plane.

8. Resonator (700) according to claim 7, in which the pattern of the second electrode (104) in the plane parallel to the plane of the first face of the piezoelectric layer (104) is similar to the pattern of the first electrode (106) in said same plane, and the surface of the contact arm (105) of the second electrode (104) in the plane parallel to the plane or the first face of the piezoelectric layer (102) is not superimposed on the surface of the contact arm (110) of the first electrode (106) in said same plane.

9. Resonator (100, 200, 300, 500, 600, 700) according to one of the previous claims, in which each finger (103) of the first electrode (106, 206, 306, 506) is substantially rectangular.

10. Resonator (100, 200, 300, 400, 500, 600, 700) according to one of the previous claims, in which the number of fingers (108, 408) of the first electrode (106, 206, 306, 406, 506) is between around 2 and 100.

11. Resonator (100, 200, 300, 400, 600, 700) according to one of the precious claims, in which the contact arm (110, 310) of the first electrode (106, 206, 306, 406) is substantially rectangular.

12. Resonator (100, 200, 300, 600, 700) according to claim 11, in which a line parallel to the two sides of each finger (108) of the first electrode (106, 206, 306), spaced apart from one another by a distance W is substantially perpendicular to a line passing through a side of the contact arm (110, 310) of the first electrode (106, 206, 306) to which said finger (108) is connected.

13. Resonator (100, 600, 700) according to one of claims 11 or 12, in which the fingers (108) of the first electrode (106) are connected to a single side, or to two opposite sides, or to three sides, of the contact arm (110) of the first electrode (106).

14. Resonator (500) according to one of claims 1 to 10, in which the contact arm (510) of the first electrode (506) comprises at least a portion (514) with a substantially circular shape, to which the fingers (108) are connected.

**15.** Method for producing a Lamb wave resonator (100, 200, 300, 400, 500, 600, 700), comprising at least one step of producing a first electrode (106, 206, 306, 406, 506) against a first face of a layer (102) composed of at least one piezoelectric material, of which the pattern, in a plane parallel to the plane of the first face of the piezoelectric layer (102), comprises at least two fingers (108, 408) and a contact arm (110, 310, 510), in which each of the fingers (108, 408) comprises a first side in contact with said arm (110, 310, 510) and two sides parallel to one another and spaced apart from one another by a distance W calculated according to she equation:

$$W = n.\frac{va_{lateral}}{f}, \qquad with \quad n \in \mathrm{N}$$

$va_{lateral}$ : acoustic propagation speed of the Lamb waves,
n: order of the resonance mode of the Lamb waves,
f: resonance frequency of the resonator,
and at least one step of at least partially etching portions (114, 116, 602) of the piezoelectric layer (102), of which the surface, at the level of the plane of the first face of the piezoelectric layer (102), is located between the fingers (108, 408) of the first electrode (106, 206, 306, 406, 506).

**16.** Method according to claim 15, also comprising a step of producing a second electrode (104) against a second face, opposite the first face, of the piezoelectric layer (102).

**Patentansprüche**

**1.** Lamb-Wellen-Resonator (100, 200, 300, 400, 500, 600, 700), umfassend wenigstens eine Schicht (102), die wenigstens eines piezoelektrischen Materials umfasst, und eine erste Elektrode (106, 206, 306, 406, 506), welche gegen eine erste Seitenfläche der piezoelektrischen Schicht (102) angeordnet ist, und deren Muster in einer zu der Ebene der ersten Seitenfläche der piezoelektrischen Schicht (102) parallelen Ebene wenigstens zwei Finger (108, 408) und einen Kontaktarm (110, 310, 510) umfasst, wobei jeder der Finger (108, 408) eine erste Seite, welche in Kontakt mit dem Arm (110, 310, 510) steht, und zwei andere zueinander parellele Seiten umfasst, die voneinander mit einem Abstand W beabstandet sind, welcher gemäß der Gleichung berechnet wird:

$$W = n.\frac{va_{lateral}}{f}, \qquad wobei \quad n \in \mathrm{N}$$

$va_{lateral}$ : die akustische Ausbreitungsgeschwindigkeit der Lamb-Wellen ist,
n: die Ordnung der Resonanzmode der Lamb-Wellen ist,
f: die Resonanzfrequenz des Resonators ist,
wobei Abschnitte (114, 116, 602) der piezoelektrischen Schicht (102), deren Fläche sich auf der Höhe der Ebene der ersten Seitenfläche der piezoelektrischen Schicht (102) zwischen den Fingern (108, 408) der ersten Elektrode (106, 206, 306, 406, 506) befindet, wenigstens teilweise graviert oder eingeprägt sind.

**2.** Resonator (700) nach Anspruch 1, wobei die Abschnitte (116) der piezoelektrischen Schicht (102) in der Ebene der ersten Seitenfläche der piezoelektrischen Schicht (102) gemäß einem eine Mehrzahl von Löchern oder Lücken umfassenden Muster graviert oder eingeprägt sind.

**3.** Resonator (100, 200, 300, 400, 500) nach Anspruch 1, wobei die Abschnitte (114) der piezoelektrischen Schicht (102) vollständig graviert oder eingeprägt sind.

**4.** Resonator (100, 200, 300, 400, 500, 700) nach einem der vorhergehenden Ansprüche, wobei die Abschnitte (114, 116) zwischen der ersten Seitenfläche der piezoelektrischen Schicht (102) und einer zweiten, der ersten Seitenfläche entgegengesetzten Seitenfläche der piezoelektrischen Schicht (102) durchquerend graviert oder eingeprägt sind.

**5.** Resonator (100, 200, 300, 400, 500, 600, 700) nach einem der vorhergehenden Ansprüche, ferner umfassend eine zweite Elektrode (104), welche gegen eine zweite, der ersten Seitenfläche entgegengesetzte Seitenfläche der piezoelektrischen Schicht (102) angeordnet ist.

**6.** Resonator (100, 200, 300, 400, 500, 600, 700) nach Anspruch 5, wobei die Fläche der Finger (108, 408) der ersten Elektrode (106, 206, 306, 406, 506) in der zu der Ebene der ersten Seitenfläche der piezoelektrischen Schicht (102) parallelen Ebene von der Fläche umfasst ist, welche durch die zweite Elektrode (104) in derselben Ebene gebildet ist.

**7.** Resonator (700) nach Anspruch 5, wobei die zweite Elektrode (104) in der zu der Ebene der ersten Fläche der piezoelektrischen Schicht (102) parallelen Ebene ein Muster umfasst, welches wenigstens zwei Finger (103) und einen Kontaktarm (105) umfasst, wobei die Fläche der Finger (103) der zweiten Elektrode (104) in der zu der Ebene der ersten Seitenfläche der piezoelektrischen Schicht (102) parallelen Ebene der von den Fingern (108) der ersten Elektrode (106) gebildeten Fläche ähnlich und in derselben Ebene überlagert ist.

**8.** Resonator (700) nach Anspruch 7, wobei das Muster der zweiten Elektrode (104) in der zu der Ebene der ersten Seitenfläche der piezoelektrischen Schicht (104) parallelen Ebene dem Muster der ersten Elektrode (106) in derselben Ebene ähnlich ist, wobei die Fläche des Kontaktarms (105) der zweiten Elektrode (104) in der zu der Ebene der ersten Fläche der piezoelektrischen Schicht (102) parallelen Ebene nicht der Fläche des Kontaktarms (110) der ersten Elektrode (106) in derselben Ebene überlagert ist.

**9.** Resonator (100, 200, 300, 500, 600, 700) nach einem der vorhergehenden Ansprüche, wobei jeder Finger (108) der ersten Elektrode (106, 206, 306, 506) eine im Wesentlichen rechtwinklige Form aufweist.

**10.** Resonator (100, 200, 300, 400, 500, 600, 700) nach einem der vorhergehenden Ansprüche, wobei die Anzahl von Fingern (108, 408) der ersten Elektrode (106, 206, 306, 406, 506) in einem Bereich von zwischen etwa 2 und 100 enthalten ist.

**11.** Resonator (100, 200, 300, 400, 600, 700) nach einem der vorhergehenden Ansprüche, wobei der Kontaktarm (110, 310) der ersten Elektrode (106, 206, 306, 406) eine im Wesentlichen rechtwinklige Form aufweist.

**12.** Resonator (100, 200, 300, 600, 700) nach Anspruch 11, wobei eine Gerade, welche parallel zu den beiden Seiten jedes Fingers (108) der ersten Elektrode (106, 206, 306) ist, welche voneinander mit einem Abstand W beabstandet sind, im Wesentlichen senkrecht zu einer Gerade ist, welche durch eine Seite des Kontaktarms (110, 310) der ersten Elektrode (106, 206, 306) verläuft, mit welcher der Finger (108) verbunden ist.

**13.** Resonator (100, 600, 700) nach einem der Ansprüche 11 oder 12, wobei die Finger (108) der ersten Elektrode (106) mit einer einzigen Seite (106), oder mit zwei entgegengesetzten Seiten, oder mit drei Seiten, des Kontaktarms (110) der ersten Elektrode (106) verbunden sind.

**14.** Resonator (500) nach einem der Ansprüche 1 bis 10, wobei der Kontaktarm (510) der ersten Elektrode (506) wenigstens einen Bereich (514) von im Wesentlichen kreisförmiger Gestalt umfasst, mit welchem die Finger (108) verbunden sind.

**15.** Verfahren zur Herstellung eines Lamb-Wellen-Resonators (100, 200, 300, 400, 500, 600, 700), umfassend wenigstens einen Schritt einer Herstellung einer ersten Elektrode (106, 206, 306, 406, 506) gegen eine erste Fläche einer Schicht (102), die wenigstens eines piezoelektrischen Materials umfasst, wobei das Muster der ersten Elektrode in einer zu der Ebene der ersten Seitenfläche der piezoelektrischen Schicht (102) parallelen Ebene wenigstens zwei Finger (108, 408) und einen Kontaktarm (110, 310, 510) umfasst, wobei jeder der Finger (108, 408) eine erste Seite, welche in Kontakt mit dem Arm (110, 310, 510) steht, und zwei zueinander parellele Seiten umfasst, die voneinander mit einem Abstand W beabstandet sind, weicher gemäß der Gleichung berechnet wird:

$$W = n.\frac{va_{lateral}}{f}, \qquad wobei \quad n \in \mathrm{N}$$

$va_{lateral}$ : die akustische Ausbreitungsgeschwindigkeit der Lamb-Wellen ist,
n: die Ordnung der Resonanzmode der Lamb-Wellen ist,
f: die Resonanzfrequenz des Resonators ist,
und einen Schritt eines wenigstens teilweisen Gravierens oder Einprägens von Abschnitten (114, 116, 602) der piezoelektrischen Schicht (102), deren Fläche sich auf der Höhe der Ebene der ersten Seitenfläche der piezoelektrischen Schicht (102) zwischen den Fingern (108, 408) der ersten Elektrode (106, 206, 306, 406, 506) befindet.

**16.** Verfahren nach Anspruch 15, ferner umfassend einen Schritt einer Herstellung einer zweiten Elektrode (104) gegen eine zweite, der ersten Seitenfläche entgegengesetzte Seitenfläche der piezoelektrischen Schicht (102).

FIG. 1

FIG. 2A

FIG. 2B

FIG. 3

108
200
102
110
206
y
x
z
108
104

FIG. 4

108
300
102
108
306
310
y
x
z
108
104

FIG. 5

FIG. 6

600

110

106

A

108

102

A

y

x

602

z

# FIG. 7A

108   602        112    106        600

y

z

x

102

104

# FIG. 7B

FIG. 8A

FIG. 8B

# RÉFÉRENCES CITÉES DANS LA DESCRIPTION

**Documents brevets cités dans la description**

• US 20060076852 A1

• WO 2004109913 A

**Littérature non-brevet citée dans la description**

• **A. Volatier et al.** UHF/VHF resonators using Lamb waves co-integrated with Bulk Acoustic Wave resonators. *IEEE Ultrasonics Symposium,* 2005, 902-905